Europäisches Patentamt

(19) **European Patent Office**

**Office européen des brevets**

(11) Numéro de publication: **0 012 889**
**B1**

(12) **FASCICULE DE BREVET EUROPEEN**

(45) Date de publication du fascicule du brevet: **30.11.83**

(51) Int. Cl.³: **H 01 L 29/10,**
**H 01 L 29/167**

(21) Numéro de dépôt: **79104894.5**

(22) Date de dépôt: **04.12.79**

(54) **Dispositif pour diminuer la sensibilité de la tension de seuil d'un MOSFET, ou d'un MISFET, aux variations de la tension appliquée au substrat.**

(30) Priorité: **29.12.78 US 974594**

(43) Date de publication de la demande:
**09.07.80 Bulletin 80/14**

(45) Mention de la délivrance du brevet:
**30.11.83 Bulletin 83/48**

(84) Etats contractants désignés:
**DE FR GB**

(56) Documents cités:
**DE - A - 2 638 867**
**US - A - 2 954 308**
**US - A - 3 449 644**

**IBM TECHNICAL DISCLOSURE BULLETIN, vol.**
**16, no. 11, avril 1974, New York, US H.S.**
**BHATIA et al. "Elimination of threshold voltage**
**shift due to avalanche injection in high-**
**performance field-effect tra nsistors" pages**
**3606-3607**

(73) Titulaire: **International Business Machines**
**Corporation**
**Old Orchard Road**
**Armonk, N.Y. 10504 (US)**

(72) Inventeur: **Crowder, Billy Lee**
**RD No. 2**
**Putnam Valley New York 10579 (US)**
Inventeur: **Gaensslen, Fritz Heinrich**
**RD No. 1 Hanover Street**
**Yorktown Heights, New York 10598 (US)**
Inventeur: **Jaeger, Richard Charles**
**1599 Gonzalo Road**
**Boca Raton, Florida 33432 (US)**

(74) Mandataire: **Colas, Alain**
**COMPAGNIE IBM FRANCE Département de**
**Propriété Industrielle**
**F-06610 La Gaude (FR)**

Courier Press, Leamington Spa, England.

(56) References cited:

**IEEE TRANSACTIONS ON ELECTRON DEVICES,
vol. ED-22, no. 1 janvier 1975 New York, US
M.E. SPROUL et al. "Temperature dependence of
turn-on voltage of gold-doped MOSFETs" pages
8-14
PROCEEDINGS OF THE INSTITUTE OF
ELECTRICAL AND ELECTRONIC ENGINEERS,
vol. 56, no. 4, avril 1968, New York US P.
RICHMAN: "The effect of gold doping upon the
characteristics of "MOS" field-effect transistors
with applied substrate voltage", pages 774,776
JOURNAL OF APPLIED PHYSICS, vol. 46, no. 1,
janvier 1975 New York, US T.F. LEE et al.
"Investigation of tellerium-implanted silicon"
pages 381-388**

## Dispositif pour diminuer la sensibilité de la tension de seuil d'un MOSFET, ou d'un MISFET, aux variations de la tension appliquée au substrat

Domaine technique

La présente invention concerne les transistors à effet de champ du type métal-oxyde-semi-conducteur (appelés MOSFET) ou métal-isolant-semi-conducteur (MISFET) et plus particulièrement, de tels transistors comportant une structure permettant de diminuer leur sensibilité aux variations de tension du substrat.

Etat de la technique antérieure

Dans les dispositifs du type MOSFET, l'application d'une charge sur l'électrode de porte provoque une inversion du type de conductivité de la région semi-conductrice située juste au-dessous de la porte et, de ce fait, modifie la conductivité entre une électrode de source et une électrode de drain. Cependant, ces dispositifs sont très sensibles à l'amplitude de la différence de potentiel existant entre la source et le substrat, ce qui oblige à augmenter la tension de seuil. L'augmentation de la tension de seuil provoque, à son tour, une diminution du niveau de courant du dispositif pour une différence de potentiel donnée entre la porte et le source. Ce phénomène entraîne une diminution du rendement des circuits utilisant de tels dispositifs.

Le problème posé par la sensibilité d'un transistor à effet de champ, aux variations de la tension appliquée à son substrat, n'est pas nouveau et l'on s'est efforcé de le résoudre en introduisant des impuretés dans le semi-conducteur.

Par exemple, les brevets des E.U.A. No. 3 449 644, 3 585 463 et 3 829 885 ainsi que l'article de Paul RICHMAN, paru dans "Proceedings of the IEEE" vol. 56 avril 1967, no. 4, pages 774—775 préconisent l'introduction d'une impureté constituée par de l'or dans diverses structures semi-conductrices pour améliorer le fonctionnement et le rendement des ces dispositifs. Cette solution présente toutefois un inconvénient, l'or tendant à se diffuser rapidement et, par conséquent à émigrer, pendant les étapes de traitement thermique et en cours d'utilisation, sauf aux températures relativement basses.

Exposé de l'invention

L'un des objets de l'invention est de pallier les inconvénients décrits ci-dessus pour diminuer la sensibilité d'un dispositif MOSFET aux variations de la tension appliquée à son substrat. Cet objet est atteint en introduisant dans la région d'ppauvrissement, située au-dessous de la porte, des impuretés présentant un niveau d'énergie suffisamment profond et une vitesse de diffusion suffisamment faible.

Pendant le fonctionnement du dispositif, dans le cas d'un transistor à canal N, les donneurs ionisés compensent partiellement la charge des accepteurs normalement présente. Cette compensation se traduit par une diminution importante de la sensibilité du dispositif aux variations de la tension appliquées au substrat.

Un autre objet de l'invention est de compenser l'augmentation de la tension de seuil, et, partant, d'améliorer les performances et le rendement des dispositifs du type MOSFET.

Ces objets sont définis dans la revendication 1 de la demande.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des Figures

La Figure 1 est une vue en coupe d'un dispositif MOSFET dont la structure est conforme à la présente invention.

La Figure 2 est un graphique représentant les variations de la tension de seuil en fonction de la tension de substrat dans le cas de dispositifs MOSFET fonctionnant soit en mode d'enrichissement soit en mode d'appauvrissement.

La Figure 3 est une représentation graphique montrant la sensibilité du dispositif MOSFET aux variations de la tension appliquée au substrat, en présence de donneurs implantés et aux températures de l'azote liquide.

La Figure 4 est une représentation graphique montrant la sensibilité du dispositif MOSFET aux variations de la tension appliquée au substrat, dans le cas de diverses concentrations de donneurs à niveaux d'énergie profonds implantés et à température ambiante.

Mode de réalisation préférée de l'invention

Dans un but de simplicité, l'invention sera expliquée ci-après en se référant à des transistors à effet de champ à canal N. Il est évident pour l'homme de l'art, que l'invention est applicable aux transistors à canal P.

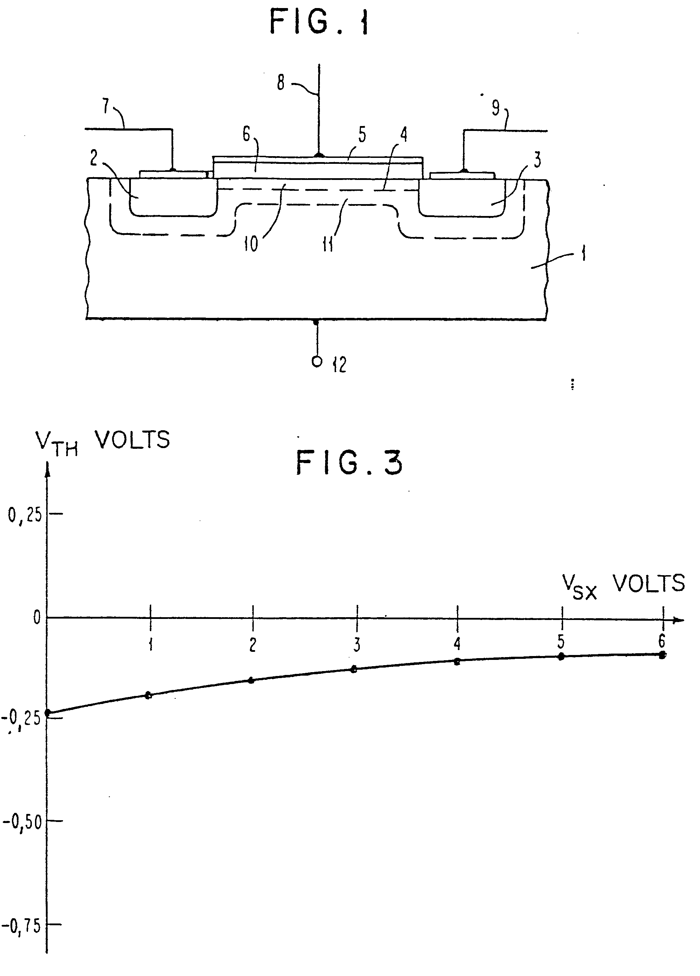

On a représenté sur la Figure 1 une coupe d'un dispositif MOSFET dans lequel un substrat 1 de type p comporte une diffusion de source 2 de type n et une diffusion de drain 3 de type n séparées par une région de canal 4 sur laquelle est disposée une porte métallique 5 qui est séparée par un oxyde 6 de la surface du substrat 1. Des électrodes externes, 7, 8, 9 et 12 sont respectivement associées à la source 2, à la porte 5, au drain 3 et au substrat 1.

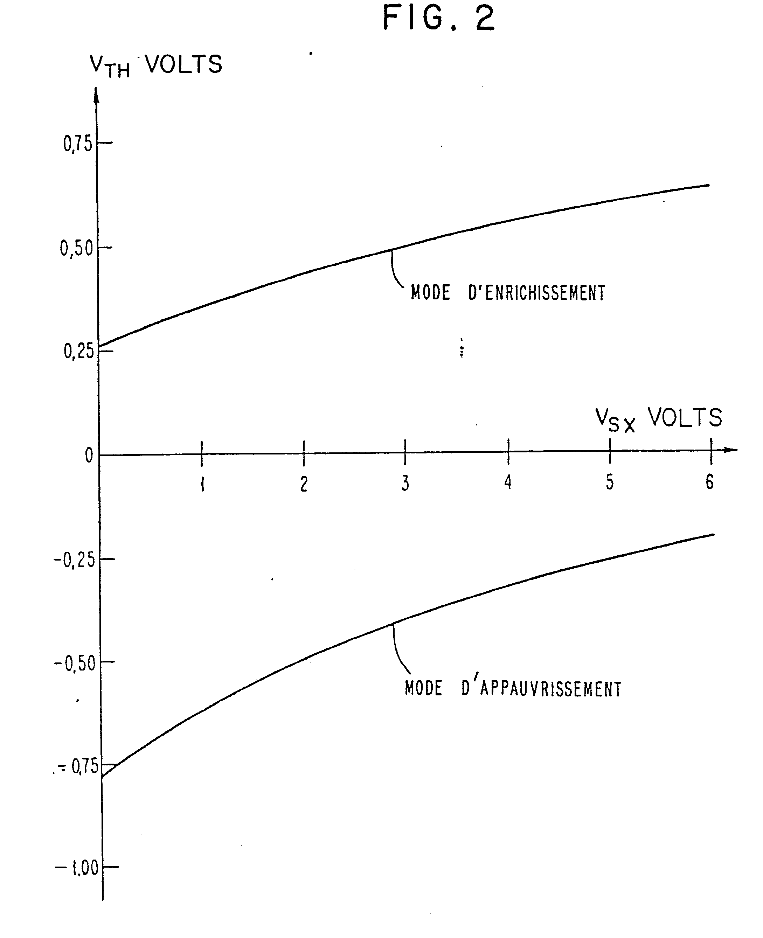

En fonctionnement, l'application, entre la porte 5 et la source 2, d'un signal d'amplitude suffisamment grande crée un canal conducteur d'électrons 10 entre la source et le drain. La tension de porte nécessaire pour créer ce canal est appelé tension de seuil et est fonction du potentiel appliqué au substrat comme le montre la Figure 2 (dans laquelle $V_{TH}$ est la tension de

seuil et $V_{sx}$ est la tension du substrat). Le canal 10 est séparé du corps du substrat par une région d'appauvrissement 11.

Dans le cas d'un fonctionnement du type "source suiveuse", le dispositif représenté sur la Figure 1 subit une augmentation de la tension de seuil, si bien que des signaux d'amplitude de plus en plus grande doivent être appliqués à l'électrode de porte 8 pour maintenir la conduction. Cette modification de la tension de seuil provoque une détérioration du rendement du circuit.

Selon la présente invention, des donneurs à niveaux d'énergie profonds sont introduits dans la région d'appauvrissement 11 suivant une concentration déterminée. En fonctionnement, ces donneurs sont ionisés et produisent une charge positive supplémentaire qui permet de compenser l'augmentation habituelle de la charge négative des accepteurs qui a lieu lorsque la différence de potentiel entre la source et le substrat augmente. Dans un dispositif normal, cette augmentation de la charge des accepteurs est la cause de l'augmentation de la tension de seuil.

Il est important qu'une relation existe entre les donneurs à niveaux d'énergie profonds et la bande de conduction, de telle sorte qu'une ionisation partielle puisse se produire sans difficulté. On considère que, à température ambiante, le niveau d'énergie convenable des donneurs est de 0,2 à 0,3 eV au-dessous du niveau du bord de la bande de conduction. Il est également important que les impuretés introduites présentent une faible vitesse de diffusion de manière à éviter leur migration, tant au cours des étapes de traitement thermique ultérieures que pendant le fonctionnement du dispositif.

La Figure 2 est un graphique représentant les variations de la tension de seuil $V_{TH}$ en fonction de la tension $V_{sx}$ appliquée au substrat dans le cas des deux types principaux de dispositifs MOSFET, c'est-à-dire des dispositifs fonctionnant respectivement dans le mode d'enrichissement et dans le mode d'appauvrissement. Dans ce dernier cas, on notera que la tension de seuil subit une variation supérieure à 0,5 volt sur une plage de tensions $V_{sx}$ comprises entre 0 et 6 volts. Dans le cas du dispositif fonctionnant dans le mode d'einrichissement, la variation est de l'ordre de 0,375 volt. Cette variation doit être prise en considération lors de l'étude de circuits faisant appel à l'emploi de tels dispositifs et impose une limite à leurs performances.

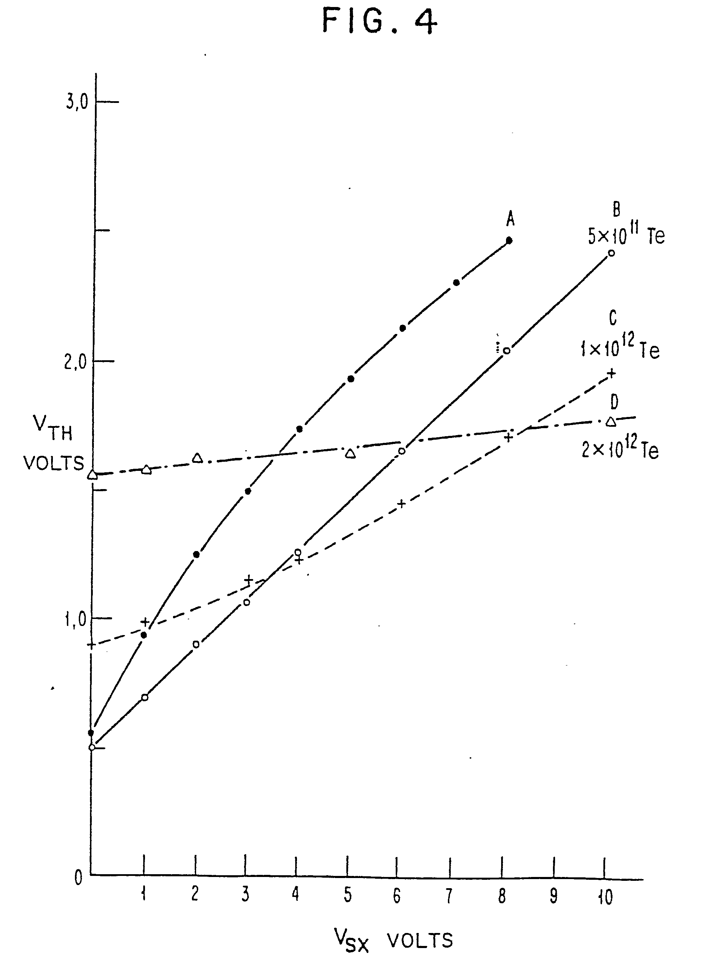

La Figure 3 illustre le comportement, à la température de l'azote liquide, d'un dispositif fonctionnant dans le mode d'appauvrissement tel que celui de la Figure 2. A cette température, une grande partie des donneurs est immobilisée, comme l'indique l'augmentation de la tension de seuil qui se produit. Lorsqu'on augmente la tension appliquée au substrat, la sensibilité du dispositif devient nettement inférieure à la sensibilité que l'on peut constater à température ambiante. Ce phénomène est dû à une ionisation plus importante des donneurs immobilisés. Une charge positive supplémentaire devient ainsi disponible, ce qui a pour effet de compenser partiellement la charge négative que l'on constate normalement dans le corps du dispositif à de telles tensions.

Selon l'invention, il est important que les donneurs présentent une faible vitesse de diffusion et des niveaux d'énergie inférieurs à celui du bord de la bande de conduction, cette valeur variant avec la température de fonctionnement. Si le dispositif fonctionne à température ambiante, on peut utiliser du tellurium comme donneur.

La Figure 4 illustre l'amélioration que la présente invention permet d'obtenir. La courbe A correspond à un dispositif témoin comportant un substrat uniformément dopé de type de conductivité p tel que le substrat 1 de la Figure 1 et dont la résistivité est d'environ 0,5 ohm-cm. Cette courbe correspond au rendement d'un dispositif typique dans lequel la présente invention n'a pas été mise en oeuvre. Les courbes B, C et D correspondent à des dispositifs pour lesquels des doses déterminées de tellurium ont été implantées dans la région 11 se trouvant au-dessous de la porte du dispositif (voir Figure 1). Les courbes B, C et D indiquent que la sensibilité du dispositif aux variations de la tension appliquée à son substrat diminue au fur et à mesure que l'on augmente la dose d'implantation du tellurium. Dans le cas de la courbe B, cette dose d'implantation est de $5 \times 10^{11}$ atomes/cm². Comme le montre la Figure, la sensibilité obtenue est meilleure que dans le cas de la courbe A. Dans le cas de la courbe C, la dose d'implantation de tellurium a été portée à $1 \times 10^{12}$ atomes/cm² et l'amélioration obtenue est encore plus importante. Dans le cas de la courbe D, où la dose d'implantation du tellurium était de $2 \times 10^{12}$ atomes/cm², la sensibilité obtenue est presque linéaire dans une plage de potentiels de substrat allant de 0 à 8 volts.

Les impuretés à niveaux d'énergie profonds peuvent être introduites par implantation ionique ou par diffusion, ou à l'aide de toute autre technique classique. La technique d'implantation ionique permet d'obtenir, au-dessous de la surface, des niveaux de concentrations indépendants les uns des autres. Cela est particulièrement avantageux, comme le montre la Figure 1, lorsque l'emplacement de la concentration désirée se trouve dans la région 11 du dispositif et que, pour diverses raisons, on désire que cette concentration soit indépendante de celle présente dans la région 10. C'est pour cette raison qu'une technique d'implantation ionique est jugée préférable.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

### Revendications

1. Dispositif semi-conducteur à effet de champ, du type métal-oxyde-semi-conducteur ou métal-isolant-semi-conducteur, du genre comportant une source (2) et un drain (3) réalisés dans un substrat (1) et séparés par une région de canal (4) ainsi qu'une porte à conduction métallique (5), ce dispositif fonctionnant en mode d'enrichissement ou en mode d'appauvrissement et étant caractérisé en ce que: des impuretés présentant des niveaux d'énergie profonds sont disposés dans la région d'appauvrissement (11) située au-dessous de la porte (5), ces impuretés étant introduites en quantité suffisante pour compenser, lors de l'ionisation, tout décalage de la tension de seuil qui résulterait d'une variation de la différence de potentiel entre ladite source et ledit substrat, et, ces impuretés présentant une faible vitesse de diffusion de manière à éviter leur migration.

2. Dispositif selon la revendication 1, caractérisé en ce que le dispositif à effet de champ est un transistor à canal N et l'impureté à niveaux d'énergie profonds est du tellurium.

3. Dispositif selon l'une des revendications 1 ou 2, caractérisé en ce que lesdites impuretés constituées par du tellurium sont implantées ioniquement.

4. Dispositif selon l'une quelconque des revendications 1 à 3, caractérisé en ce que le niveau d'énergie desdites impuretés à niveaux d'énergie profonds est situé entre 0,2 et 0,3 eV au-dessous du niveau du bord de la bande de conduction correspondant au type de porteurs utilisés.

### Patentansprüche

1. Halbleitervorrichtung mit Feldeffekttransistor vom Typ Metall-Oxid-Halbleiter oder Metall-Isolator-Halbleiter der Art, die in einem Substrat (1) eine Sourcezone (2) und eine Drainzone (3) umfaßt, die durch eine Kanalzone (4) sowie auch durch ein metallisches Gate (5) voneinander getrennt sind, wobei die genannte Vorrichtung in Anreicherungsoder in Verarmungsweise arbeitet und dadurch gekennzeichnet ist, daß die Störstellen, die tiefe Energiepegel besitzen, in der Verarmungsrandschicht (11) angeordnet sind, welche ihrerseits unterhalb des Gates (5) liegt und daß diese Störstellen in ausreichender Menge eingebracht werden, um bei der Ionisation jede Abweichung der Schwellenspannung zu kompensieren, die durch eine Änderung der Spannungsdifferenz zwischen der genannten Sourcezone und dem genannten Substrat auftreten könnte, und um eine Auswanderung der Störstellen zu vermeiden, da letztere nur eine geringe Diffusionsgeschwindigkeit aufweisen.

2. Vorrichtung nach Patentanspruch 1, dadurch gekennzeichnet, daß die genannte Vorrichtung ein Feldeffekttransistor mit einer n-Kanalzone ist, dessen Störstellen mit tiefem Energiepegel aus Tellur bestehen.

3. Vorrichtung nach einem der Patentansprüche 1 oder 2, dadurch gekennzeichnet, daß die genannten Störstellen aus Tellur durch Ionenimplantation eingebracht werden.

4. Vorrichtung nach einem der Patentansprüche 1 bis 3, dadurch gekennzeichnet, daß der Energiepegel der genannten Störstellen mit tiefen Energiepegeln um 0,2 bis 0,3 Elektronenvolt unter dem Pegel der Bandkante liegt, die dem verwendeten Leitungssträgertyp zugeordnet ist.

### Claims

1. Field effect semiconductor device, of the metal oxide semiconductor or metal insulator semiconductor type, and of the type comprising a source (2) and a drain (3) formed in a substrate (1) and separated by a channel region (4) and a metal conducting gate (5), this device operating in the enhancement mode or the depletion mode and being characterized in that: impurities with wide energy levels are included in the depletion region (11) below the gate (5), these impurities being incorporated in sufficient quantity to compensate, during ionisation, any change in the threshold voltage which would lead to a change in the potential difference between said source and said substrate, and these impurities having a low diffusion speed to prevent their migration.

2. Device according to claim 1, characterized in that the field effect device is a n-channel transistor and the impurity with wide energy levels is tellurium.

3. Device according to any one of the claims 1 or 2, characterized in that said impurities consisting of tellurium are implanted ionically.

3. Device according to any one of the claims 1 to 3, characterized in that the energy level of said impurities with wide energy levels is between 0.2 and 0.3 eV below the edge level of the conduction band corresponding to the type of carries used.

# FIG. 1

# FIG. 3

# FIG. 2

0012889

FIG. 4

3

$V_{TH}$ VOLTS

$V_{SX}$ VOLTS

A

B
$5 \times 10^{11}$ Te

C
$1 \times 10^{12}$ Te

D
$2 \times 10^{12}$ Te